# EUROPÄISCHE PATENTANMELDUNG

(11) **EP 2 355 170 A2**
(43) Veröffentlichungstag der Anmeldung: **10.08.2011**
(21) Anmeldenummer: 11000893.5
(22) Anmeldetag: 04.02.2011
(51) Int. Cl.: H01L 31/042, H01L 31/02

(54) **Steuerung für Fotovoltaik-Anlagen**

(30) Priorität: 13.11.2010 DE 102010051360; 09.02.2010 DE 102010007484
(71) Anmelder: Emmert, Markus, 86477 Adelsried (DE)
(72) Erfinder: Emmert, Markus, 86477 Adelsried (DE)
(74) Vertreter: Gallo, Wolfgang

(57) **Zusammenfassung**

Fotovoltaik-Anlage mit einer Mehrzahl von Fotovoltaik-Modulen und einer Anzahl von Wechselrichtern, wobei die Anzahl von Fotovoltaik-Modulen mehrere Gruppen von jeweils mehreren Modulen (1) umfasst, die mit dem Gleichstromeingang jeweils eines der Wechselrichter (2) verbunden sind, mit einer Steuereinrichtung (3), welche variabel die Verbindungen zwischen den Modulen (1) und den Wechselrichtern (2) so steuert, dass bei nur geringen Ausgangsleistungen bzw. Ausgangsspannungen der Module so viele Module auf mindestens einen Wechselrichter in Reihe geschaltet werden, dass dessen Mindesteingangsspannung überschritten wird.

## Beschreibung

Die Erfindung betrifft eine Steuerung von Fotovoltaik-Anlagen zur Erzeugung von Wechselstrom aus Solarenergie.

Solche Fotovoltaik-Anlagen bestehen aus einer Mehrzahl von gewöhnlich plattenförmigen Fotovoltaik-Modulen, die auf Da̅chern, an Wänden oder auf Gestellen angeordnet sind, um Sonnenlicht aufzunehmen und in elektrischen Strom umzuwandeln.

Dadurch erzeugt jedes Fotovoltaik-Modul an seinem Ausgang eine elektrische Spannung und einen entsprechenden elektrischen Strom, deren Größe von der Intensität des auftreffenden Lichts abhängig ist.

Ein Fotovoltaik-Modul besteht aus einer Mehrzahl von Fotovoltaik-Zellen, die auf einer Platte angeordnet sind. Diese Zellen nehmen das Sonnenlicht auf und wandeln die Lichtenergie in Gleichstrom um. Die Zellen sind innerhalb des Moduls in Reihe geschaltet, so dass sich ihre Ausgangsspannungen zu einer Gesamtausgangsspannung des Moduls addieren. Jeder Modul hat einen Gleichspannungsausgang mit einem Plus- und einem Minuspol.

Da die Intensität der Sonneneinstrahlung je nach Tageszeit, Wetterlage, Bewölkung, Abschattung durch andere Objekte, und Einfallswinkel bei direkter Sonneneinstrahlung stark unterschiedlich ist, ist auch die vom jeweiligen Modul erzeugte Spannung entsprechend unterschiedlich.

Den Fotovoltaik-Modulen wird ein Wechselrichter nachgeschaltet, der den von den Modulen erzeugten Gleichstrom in Wechselstrom umwandelt, dessen Spannung der Netzspannung entspricht, und der verbraucht oder in das Wechselstromnetz eingespeist werden kann.

Damit die Wechselrichter arbeiten können, muss die auf der Gleichstromseite jedes Wechselrichters anliegende Eingangsspannung einen bestimmten Mindestwert erreichen, darf andererseits aber einen bestimmten Maximalwert nicht überschreiten, damit der Wechselrichter nicht durch Überspannungsbetastung beschädigt oder zerstört wird. Da die von den einzelnen Fotovoltaik-Modulen erzeugte Spannung jeweils relativ klein ist, wird jedem Wechselrichter eine Gruppe von mehreren solchen Modulen zugeordnet, die entweder schon durch gegenseitige Verkabelung oder im Eingangsbereich des zugeordneten Wechselrichters in Reihe geschaltet sind, so dass sich ihre jeweiligen Ausgangsspannungen am Gleichstromeingang des Wechselrichters zu einer Gesamtspannung addieren. Wie viele Fotovoltaik-Module zu einer Reihengruppe zusammengeschaltet und einem bestimmten Wechselrichter zugeordnet werden, hängt natürlich von den Kenngrößen der einzelnen Module und des Wechselrichters zusammen. Um eine Überlastung des Wechselrichters durch Überspannung zu vermeiden, darf die Gruppe von ihm zugeordneten Fotovoltaik-Modulen nur so viele Module umfassen, dass bei der maximal erwarteten Lichtintensität durch die aufsummierte Gesamtspannung dieser Module die zulässige Eingangsgleichspannung am Wechselrichter nicht überschritten wird. Gleiches gilt auch für die Stromstärke und die daraus resultierende Leistung.

Dabei muss allerdings in Kauf genommen werden, dass im unteren Bereich der Lichtintensitäten keine Wechselstromerzeugung möglich ist, weil dann die am Gleichstromeingang des Wechselrichters anliegende aufsummierte Gesamtspannung der Module die für den Betrieb des Wechselrichters notwendige Mindesteingangsspannung nicht mehr erreicht. Diese Mindesteingangsspannung liegt etwa im Bereich von 20 % der maximalen Eingangsspannung. Dies bedeutet, dass in einem Bereich von bis zu etwa 20 % der maximal auftretenden Lichtintensität diese Mindesteingangsspannung nicht erreicht wird, und dass daher kein nutzbarer Strom mehr erzeugt werden kann. Dieser nicht nutzbare untere Bereich der Beleuchtungsstärken an den Fotovoltaik-Modulen tritt stets über eine gewisse Zeitspanne während der Morgendämmerung und der Abenddämmerung auf, kann aber auch tagsüber bei Nebel, starker Bewölkung oder Abschattung oder anderen ungünstigen Verhältnissen anhaltend vorliegen.

Bei der üblichen Reihenschaltung von Modulen können an einer Modulreihengruppe Spannungen von bis zu 1000 Volt auftreten. Da bereits ab etwa 120 Volt Gleichstrom bei einem Stromschlag eine akute Lebensgefahr besteht, sind Fotovoltaik-Anlagen, insbesondere Dachanlagen, gefährlich, wenn tagsüber, also während der Betriebsphase, während aufgrund von Sonneneinstrahlung Spannung erzeugt wird, in die Modulreihe eingegriffen wird, beispielsweise bei Wartungsarbeiten. Eine besondere Stromschlaggefahr besteht auch beim Löschen von Bränden.

Die Stromerzeugung durch Fotovoltaik-Anlagen gehört zum Konzept der erneuerbaren Energien, wo im Vergleich zur Stromerzeugung aus fossilen Energieträgern oder Atomenergie relativ hohe Gestehungskosten aufgewendet werden müssen, so dass vielfach Investitionen in erneuerbare Energien nur durch Subventionen herbeigeführt werden können. Deshalb ist es aber erforderlich, möglichst effiziente Materialien und Methoden einzusetzen, um das Kosten-Nutzen-Verha̅ltnis zu verbessern. Das Erzielen einer möglichst hohen Effizienz ist daher insbesondere bei einer mit erneuerbaren Energien arbeitenden Stromerzeugungsanlage erforderlich, wozu Fotovoltaik-Anlagen gehören.

Der Erfindung liegt daher die Aufgabe zugrunde, Fotovoltaik-Anlagen so auszubilden, dass auch im unteren Liehtintensitätsbereich, wo bei herkömmlichen Anlagen die Schwellenspannung des Wechselrichters noch nicht erreicht wird und daher die erzeugte Gleichspannung noch nicht nutzbar ist, trotzdem noch eine effektive Wechselstromerzeugung möglich ist und damit die Ausbeute einer Fotovoltaik-Anlage deutlich gesteigert werden kann.

Dabei soll auch die Möglichkeit geschaffen werden, eine laufende Überwachung bzw. Messung des elektrischen Ausgangs jedes Moduls vornehmen zu können und jeden Modul bei Bedarf von der Anlage abtrennen zu können, sei es wegen eines festgestellten Defekts in dem betreffenden Modul, oder sei es zum Schutz von Personen bei Wartungsarbeiten, Schaltarbeiten oder Feuerlöscharbeiten, so dass immer nur noch die ungefährlichen Ausgangsspannungen der einzelnen Module für sich genommen jeweils vorhanden sind.

Diese Aufgabe wird gemäß der Erfindung durch die im Anspruch 1 angegebene Anordnung gelöst.

Im Gegensatz zu herkömmlichen Fotovoltaik-Anlagen, bei denen jedem Wechselrichter eine feste Anzahl von Fotovoltaik-Modulen zugeordnet und in festverdrahteter Reihenschaltung mit dem Wechselrichter verbunden ist, sieht die erfindungsgemäße Steuerung eine variable Zuordnung von Fotovoltaik-Modulen einer Anlage zu den Wechselrichtern der Anlage vor. Die Fotovoltaik-Module sind einzeln oder auch in Kleingruppen direkt mit der Steuerung verbunden, mit welcher auch die Wechselrichter der Anlage verbunden sind. Eine Modul-Kleingruppe kann dabei beispielsweise zwei oder mehr Module umfassen, die zusammen nur einen Bruchteil einer bisher üblichen Gruppe von einem Wechselrichter fest zugeordneten Modulen umfasst. Die Steuerung misst die momentane Ausgangsspannung jedes einzelnen, an der Steuerung angeschalteten Fotovoltaik-Moduls oder jeder einzelnen an die Steuerung angeschalteten Modul-Kleingruppe und errechnet anhand der programmierten Kenndaten der Wechselrichter, die auch bei Verwendung unterschiedlicher Wechselrichter in einer Anlage von Wechselrichter zu Wechselrichter verschieden sein können, wie viele Module oder Modul-Kleingruppen zusammen geschaltet werden müssen, damit ihre aufsummierten Einzelspannungen oberhalb des Eingangs-Spannungsschwellenwerts eines bestimmten Wechselrichters liegen. Aufgrund dieser Berechnungen schaltet dann die Steuerung jeweils so viele Module oder Module-Kleingruppen auf einen bestimmten Wechselrichter, dass dieser arbeiten kann.

Bei ungünstigen Lichtintensitätsverhaltnissen werden dadurch jeweils mehr Fotovoltaik-Module auf einen Wechselrichter geschaltet, als dies bei der herkömmlichen festen Zuordnung einer bestimmten festen Anzahl von Modulen zu einem bestimmten Wechselrichter der Fall ist. Je nach dem, wie viele Module dann auf jeweils einen Wechselrichter geschaltet werden müssen, damit an dessen Gleichstromeingang die Mindestspannung anliegt und er arbeiten kann, wird dann unter ungünstigen Lichtintensitätsverhaltmssen nur noch ein mehr oder weniger großer Teil der in einer Anlage insgesamt vorhandenen Wechselrichter mit Modulen zusammcngeschaltet. Mindestens einer der Wechselrichter wird damit außer Betrieb genommen. Während unter solchen Verhältnissen bei herkömmlichen Anlagen keiner der Wechselrichter mehr arbeiten kann und folglich die Anlage keinen nutzbaren Wechselstrom liefert, arbeitet bei dem erfindungsgemäßen Konzept auch unter sehr ungünstigen Verhältnissen noch mindestens ein Teil der Wechselrichter und erzeugt nutzbaren Wechselstrom. Die Ausbeute der Anlage kann dadurch gegenüber herkömmlichen Anordnungen um etwa 15 bis 20 % gesteigert werden.

Lässt die Messung der Ausgangsspannung eines bestimmten Moduls darauf schließen, dass in diesem ein Defekt vorliegt, kann er durch Abtrennen aus der Anlage herausgenommen werden. Ebenso kann über die Steuerung bei Bedarf die Abtrennung aller Module oder eines Teils der vorhandenen Module vorgenommen werden, um Wartungsarbeiten oder Schaltarbeiten oder ähnliches zu ermöglichen.

Die Erfindung wird nachstehend unter Bezugnahme auf ein Ausführungsbeispiel mehr im Einzelnen beschrieben.

Die anliegende schematische Zeichnung zeigt eine gemäß der Erfindung ausgebildete Fotovoltaik-Anlage nach Art eines Blockschaltbilds.

Die Anlage umfasst eine größere Anzahl von Fotovoltaik-Modulen 1 (beispielsweise 36 solche Module sind schematisch dargestellt) und eine kleinere Anzahl von Wechselrichtern 2 (im Ausführungsbeispiel sind drei Wechselrichter dargestellt), sowie eine Steuereinrichtung 3.

Die Steuereinrichtung 3 weist eine mindestens der Anzahl von Fotovoltaik-Modulen 1 entsprechende Anzahl von Eingängen 4 auf Jedes Fotovoltaik-Modul 1 ist mit seinem Ausgang direkt mit einem Eingang 4 der Steuereinrichtung 3 verbunden.

Alternativ können auch Kleingruppen von Fotovoltaik-Modulen zusammengefasst sein, beispielsweise jeweils zwei oder mehr zusammengeschaltete Module, die dann mit jeweils einem Eingang der Steuereinrichtung verbunden sind, wobei dann die Anzahl der Eingänge der Steuereinrichtung der Anzahl der Kleingruppen entspricht. Die Module einer Kleingruppe können in beliebiger Weise untereinander verschaltet sein, also auch in Parallelschaltung. Die Steuereinrichtung kann auch von vornherein mit einer größeren Anzahl von Eingängen ausgeführt sein, um einen späteren Ausbau der Fotovoltaik-Anlage zu ermöglichen.

Jeder Eingang 4 der Steuereinrichtung 3 ist mit einer Messeinrichtung verbunden oder verbindbar, welche die Spannung und vorzugsweise auch den Strom am jeweiligen Eingang misst. Damit erfasst die Steuereinrichtung individuell die von jedem Modul (oder von jeder Modul-Kleingruppe) bereitgestellte Spannung und vorzugsweise auch den gelieferten Strom, woraus sich die jeweilige Leistung des Moduls (oder der Modul-Kleingruppe) ergibt.

Die Steuereinrichtung 3 weist weiter eine (nicht eigens dargestellte) Zentraleinheit auf, welcher die Spannung- und gegebenenfalls Strotzumesswerte jedes Eingangs 4 zugeführt werden. Die Zentraleinheit enthält einen Rechner, der aufgrund einprogrammierter Kenndaten der Wechselrichter 2, nämlich insbesondere deren Mindesteingangsspannung auf der Gleichstrom-Eingangsseite und maximale Eingangsspannung oder Leistung, und anhand der gelieferten Messdaten die optimale Zuordnung der einzelnen Module 1 (oder Modul-Kleingruppen) zu den einzelnen Wechselrichtern 2 ermittelt, damit auch bei schwacher Leistung der einzelnen Module bei ungünstigen Lichtverbältnissen eine möglichst große Ausbeute an nutzbarem Wechselstrom erreicht werden kann.

Die Zentraleinheit oder jedenfalls der Rechner braucht nicht intern in der Steuereinrichtung angeordnet zu sein. Sie bzw. er kann auch extern, zum Beispiel in einer Fernwarte, vorgesehen sein und über eine Datenaustauschverbindung mit der übrigen Steuereinrichtung verbunden sein.

Die Anlage ist so konzipiert, dass im Hinblick auf die vorhandene Anzahl und die Leistungsfähigkeit der Module die Anzahl und die Leistungsfähigkeit der Wechselrichter so gewählt ist, dass diese bei der erwarteten maximalen Lichtintensität die von den Modulen dann gelieferten Gleichstrommengen noch verarbeiten können. Dementsprechend ist auch die Reihe von jedem Wechselrichter zugeordneten Modulen so konzipiert, dass bei der erwarteten maximalen Lichtintensität die am Wechselrichter anliegende Eingangsspannung den zulässigen Wert noch nicht übersteigt und der gelieferte Strom vom Wechselrichter aufgenommen werden kann.

Ist die Lichtintensität relativ niedrig, so dass Ausgangsspannung und Ausgangsleistung der einzelnen Module oder Modul-Kleingruppen auf einen Wert abgefallen sind oder einen so niedrigen Wert haben, dass der betreffende Wechselrichter nicht mehr effizient arbeiten kann oder gar die erforderliche Mindesteingangsspannung nicht mehr erreicht wird, gruppiert die Zentraleinheit die Zuordnung der Module oder Modul-Kleingruppen zu den Wechselrichtern so um, dass eine größere Anzahl von Modulen, nämlich so viele Module auf einen bestimmten Wechselrichter geschaltet werden, dass dieser arbeiten kann. Dann arbeitet zwar nur noch ein Teil der Wechselrichter, weil dann auf einen oder mehrere Wechselrichter keine Module mehr ausgeschaltet sind, aber es wird auch bei ungünstigen Bedingungen noch nutzbarer Wechselstrom erzeugt, wa̅hrend bei herkömmlichen Anlagen keiner der Wechselrichter mehr arbeiten kann und keine nutzbare Stromerzeugung erfolgen kann.

So steuert die Zentraleinheit eine Schaltzentrale 5 der Steuereinrichtung 3, mit welcher die Eingänge 4 der Steuereinrichtung und die Eingänge der Wechselrichter 2 verbunden sind. Unter der Steuerung der Zentraleinheit konfiguriert also die Schaltzentrale 5 die Verbindungen zwischen den Eingängen 4 der Steuereinrichtung und den Eingängen der Wechselrichter 2 in der genannten Weise um.

Ebenso konfiguriert die Steuereinrichtung die Zuordnung der Module (oder Modul-Kleingruppen) zu den Wechselrichtern um, wenn die Verhältnisse sich von niedriger Lichtintensität auf höhere oder hohe Lichtintensität verändern, damit dann die Ausgangsleistung der Module (oder Modul-Kleingruppen) auf mehr Wechselrichter verteilt wird.

Die Steuereinrichtung 3 weist auch eine als Block 10 schematisch dargestellte Abschalteinrichtung auf, die das wahlweise Abtrennen einzelner oder aller Module oder Modulkleingruppen von der Anlage ermöglicht. Abtrennen von der Anlage bedeutet hier, dass der jeweilige Eingang 4 der Steuereinrichtung 3, auf welchen der jeweilige Modul oder die jeweilige Modulgruppe geschaltet ist, von der übrigen Anlage abgetrennt ist, so dass das betreffende Modul oder die betreffende Modulkleingruppe isoliert da steht und bei Lichteinstrahlung an ihren Anschlüssen lediglich die von dem Modul oder der Modulkleingruppe selbst erzeugte ungefährliche Spannung anliegt, die sich mit keiner Spannung eines anderen Moduls mehr addieren kann.

Weiter ist schematisch eine Schnittstelle 11 dargestellt, über welche Messdaten von der Steuereinrichtung zu einer Überwachungsstelle übertragen werden können, über welche aber auch in der Gegenrichtung Daten oder Steuerbefehle von einer Fernwarte zu der Steuereinrichtung 3 übertragen werden können.

Beispielsweise können die an den einzelnen Modulen oder Modulkleingruppen jeweils gemessenen Spannungs- und gegebenenfalls Stromwerte übertragen werden, und es kann auch die jeweilige Konfiguration der Anlage, also die jeweils momentane Zuordnung der Module oder Modulkleingruppen zu den vorhandenen Wechselrichtern übermittelt werden, um eine Aufzeichnung und Dokumentation zu ermöglichen.

Die Abschalteinrichtung 10 kann dann ebenfalls von einer Fernwarte aus ferngesteuert werden, um einzelne Module oder Modulkleingruppen wahlweise abzutrennen, oder um Modulreihen oder bestimmte Bereiche einer größeren Anlage abzuschalten. Es versteht sich, dass die Abschalteinrichtung 10 auch einen oder mehrere an geeigneten Stellen, nämlich an der Steuereinrichtung oder an davon entfernten Orten, befindliche Notausschalter aufweisen kann, um im Gefabrenfall, beispielsweise bei beabsichtigten Wartungs- oder Schaltarbeiten oder bei einem Lo̅scheinsatz, die Module abschalten zu können.

Die oben erwähnte Messung der Ausgangsspannung jedes Moduls oder jeder Modulkleingruppe kann kontinuierlich oder intermittierend erfolgen. Denkbar wäre eine Multiplexenrichtung, mit der eine einzige, allen oder einer Anzahl von Modulen oder Modulkeingruppen zugeordnete Messeinrichtung nacheinander die Messungen an den einzelnen Modulen oder Modulkleingruppen vornimmt.

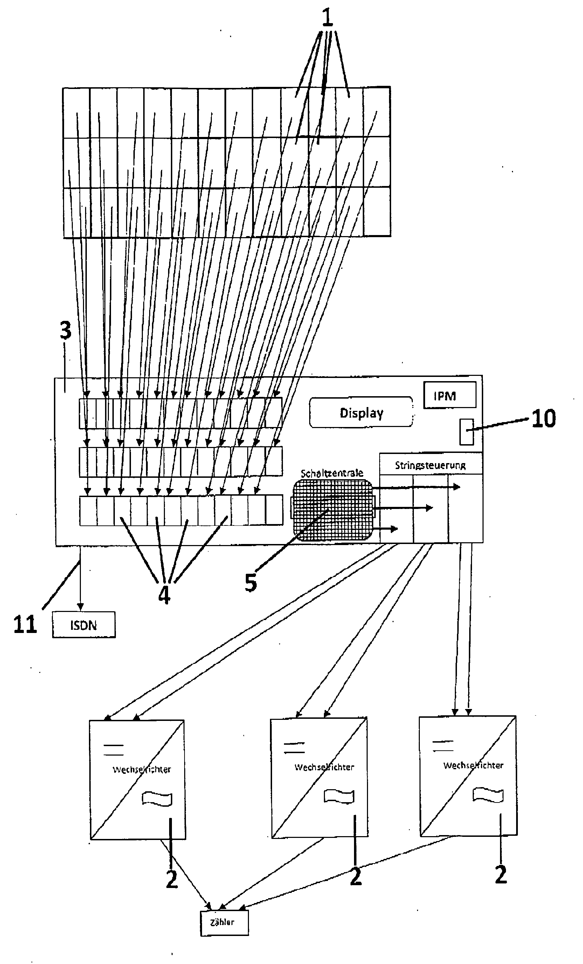

An den Wechselrichtern können die Eingangsspannungen und Eingangsströme sowie die Ausgangsspannungen und Ausgangsströme kontinuierlich oder intermittierend gemessen werden, und die jeweilige Leistung wird ohne über einen in der Zeichnung ebenfalls angedeuteten Zähler erfasst.

Zu den Vorteilen der erfindungsgemäßen Anordnung gehört auch eine große Flexibilität. Ein Austausch von Fotovoltaik-Modulen gegen solche höherer Leistung ist ebenso möglich wie ein Austausch bestehende Wechselrichter gegen andere Wechselrichter mit anderen Kenndaten, was insbesondere dann von Bedeutung ist, wenn nach etlichen Jahren Betrieb defekte Komponenten ausgetauscht werden müssen, weil dann möglicherweise Komponenten mit den ursprünglichen Kenngro̅ßen nicht mehr zur Verfügung stehen. Unterschiedlich leistungsstarke Module oder Modul-Kleingruppen werden ebenso wie Wechselrichter unterschiedlicher Leistung bei der Berechnung der optimalen Konfiguration der Anlage bei allen Lichtverbältnissen automatisch berücksichtigt.

## Patentansprüche

1. Steuerung für Fotovoltaik-Anlagen, die eine gro̅ßere Anzahl von Fotovoltaik-Modulen (1) in Gestalt von Einzelmodulen oder Modulkleingruppen zur fotovoltaischen Erzeugung von Gleichstrom aufgrund einfallenden Lichts, und eine kleinere Anzahl von mindestens zwei Wechselrichtern (2) umfassen, und wobei die Mehrzahl von Fotovoltaik-Modulen (1) mehrere Gruppen von jeweils mehreren in Reihe geschalteten Modulen umfasst, und wobei die Module jeder Gruppe mit dem Gleichspannungseingang jeweils eines der Wechselrichter (2) verbunden ist,
**gekennzeichnet durch** eine Steuereinrichtung (3), die eine variable Zuschaltung der Fotovoltaik-Module (1) auf alle oder nur einen Teil der Wechselrichter (2) ermöglicht, mit einer mindestens der Anzahl der Module (1) entsprechenden Anzahl von Eingängen (4), an die jeweils ein Modul (1) angeschlossen ist, weiter mit mindestens einer Messeinrichtung, die ein kontinuierliches oder intermittierendes Messen der an jedem Eingang (4) anliegenden Gleichspannung ermöglicht,
ferner mit einer Schalteinrichtung (5), die mit den Eingängen (4) einerseits und mit den Gleichstromemgängen der Wechselrichter (2) andererseits verbunden ist und das wahlweise Zusammenschalten jedes Eingangs (4) mit anderen Eingängen (4) zu einer Reihenschaltung und das Zusammenschalten dieser Reihenschaltung mit dem Gleichstromeingang eines beliebigen der Wechselrichter (2) ermöglicht,
und mit einem internen oder externen Rechner, der die Schalteinrichtung (5) aufgrund der bekannten Kenndaten der Wechselrichter (2) und den gemessenen Eingangsspannungen an jedem der Eingänge (4) jeweils so steuert, dass die Summe der Spannungen an der jeweils in Reihenschaltung mit jeweils einem Wechselrichter (2) verbundenen Einga̅ngen (4) eine zulässige Eingangsspannung des Wechselrichters nicht überschreitet, andererseits aber beim Anliegen nur geringer Eingangsspannwagen an den Eingängen (4) **durch** Umkonfigurieren der Reihenschaltungen so viele Eingänge (4) in die dem Gleichspannungseingang eines bestimmten Wechselrichters zugeordnete Reihenschaltung einfügt, dass dessen Mindesteingangsspannung überschritten wird.

2. Steuerung nach Anspruch 1, wobei die Steuereinrichtung (3) eine Abschalteinrichtung (10) aufweist, mit welcher einzelne oder mehrere oder alle Module (1) durch Abtrennen des jeweiligen Eingangs (4) von der übrigen Anlage abgetrennt werden können.

3. Steuerung nach Anspruch 2, wobei die Abschalteinrichtung über eine Fernwarte fernsteuerbar ist.
